# EUROPÄISCHE PATENTSCHRIFT

(11) **EP 1 868 238 B1**
(45) Veröffentlichungstag und Bekanntmachung des Hinweises auf die Patenterteilung: **13.02.2013**
(21) Anmeldenummer: 07109053.4
(22) Anmeldetag: 29.05.2007
(51) Int. Cl.: H01L 21/687

(54) **Klemmvorrichtung für einen Wafer**
Clamping device for a wafer
Dispositif de serrage pour une plaquette de silicium

(30) Priorität: 14.06.2006 DE 102006027666
(43) Veröffentlichungstag der Anmeldung: 19.12.2007
(73) Patentinhaber: ASM Assembly Systems GmbH & Co. KG, 81379 München (DE)
(72) Erfinder: Plattner, Rudolf, 94501 Aldersbach (DE)
(74) Vertreter: Patentanwälte Bals & Vogel

(56) Entgegenhaltungen:
- EP-A- 1 253 633
- JP-A- 10 296 072
- US-A1- 2003 098 048
- US-B1- 6 578 853

## Beschreibung

Die vorliegende Erfindung betrifft die Zuführung von ungehäusten Bauelementen von einem Wafer hin zu einer Abholposition zum Zwecke der Abholung der Bauelemente von einem Bestückkopf. Die Erfindung betrifft insbesondere eine Klemmvorrichtung zum lösbaren Fixieren eines Wafers auf einem verfahrbaren Wafertisch.

Die Erfindung betrifft ferner eine Zuführvorrichtung für in einem Wafer befindliche ungehäuste und vereinzelte Bauelemente hin zu einer Abholposition, insbesondere zum Zwecke der Bereitstellung der Bauelemente für einen Bestückautomaten.

Ferner betrifft die Erfindung eine Bestückvorrichtung zum automatischen Bestücken von Bauelementeträgern mit Bauelementen.

Aufgrund der zunehmenden Miniaturisierung von elektronischen Bauelementen wird es bereits in naher Zukunft nicht mehr wirtschaftlich sein, elektronische Bauelemente, welche auf ein elektronisches Schaltungssubstrat bestückt werden sollen, zum Zwecke einer sicheren Bauelement-Zuführung für einen Bestückprozess umzupacken. Ein derartiges Umpacken in spezielle Bauelement-Zuführgurte ist heutzutage üblich, um die Bauelemente einzeln dem Bestückprozess zuzuführen. Von modernen Bestücksystemen wird vielmehr verlangt, dass sie die Bauelemente unmittelbar von einem Wafer entnehmen und auf entsprechende Stellen eines elektronischen Schaltungssubstrats bzw. Bauelementeträgers aufsetzen.

Um die Handhabung von ungehäusten elektronischen Bauelemente (sog. Bare Dies) zu vereinfachen, wird der gesamte Wafer vor einer Bauelement-Vereinzelung auf einer klebrigen Trägerfolie aufgebracht. Die Vereinzelung erfolgt üblicherweise durch einen hochpräzisen mechanischen Säge- oder durch einen hochpräzisen chemischen Ätzvorgang.

Von der Trägerfolie werden die Bauelemente von einem Sauggreifer entnommen und einem Bestückprozess zugeführt. Ein Ablösen der Bauelemente von der klebrigen Trägerfolie wird in bekannter Weise durch sog. Ausstoßnadeln unterstützt, welche beispielsweise aus der EP 565781 A1 bekannt sind.

Für einen zuverlässigen Bestückprozess ist es erforderlich, dass die einzelnen Bauelemente möglichst genau an einer Aufnahmeposition eines Bestückautomaten bereitgestellt werden, damit sie von einem Bestückkopfes mittels einer Haltevorrichtung, typischerweise ein Sauggreifer, aufgenommen werden. Aus diesem Grund ist eine stabile lösbare Fixierung des Wafers auf einem Positioniertisch, welcher häufig auch als Wafertisch bezeichnet wird, unbedingt erforderlich. Die Fixierung eines Wafers nicht nur an einem Positionier- bzw. Wafertisch erfolgt in bekannter Weise durch sog. Waferklemmungen.

Aus der JP 11-116046 A ist ein Roboterarm zum Transport eines Wafers bekannt. Der Roboterarm weist eine mit einem mechanischen Stellglied gekoppelte linear verschiebbare Klemmbacke auf, die in einer Fixierposition einen Wafer gegen eine feste Klemmbacke drückt.

Aus der JP 07-037969 A ist eine Roboterhand zum Aufnehmen eines Wafers bekannt. Die Roboterhand weist einen Antrieb auf, der mechanisch mit drei Klemmfingern gekoppelt ist, so dass durch eine entsprechende Ansteuerung des Antriebs gleichzeitig alle drei Klemmfinger in geeigneter Weise bewegt werden können, um einen Wafer zu fixieren oder um einen fixierten Wafer freizugeben.

Aus der EP 0 250 064 A2 ist eine Vorrichtung zum Halten und Transportieren von Wafern bekannt. Dabei wird ein Wafer zwischen einem in einer Greifposition gedrehten Klemmstift und einem Tragelement eingespannt. In dieser Stellung wird der Wafer durch die Federspannkraft einer Feder eines Greiferantriebs gehalten.

Aus der JP 11-181565 A ist eine Halterung für einen Wafer bekannt, bei welcher Halterung der Wafer in einem zweiteiligen Ring festgeklemmt wird. Ein mittels eines Stellgliedes bewegliches Stützelement erlaubt ein automatisches Schließen und Öffnen des Rings.

Aus der EP 0 250 064 A2 ist eine Spannvorrichtung für einen Wafer bekannt. Die Spannvorrichtung weist abhängig von dem Durchmesser des zu spannenden Wafers eine Vielzahl von Einzelklemmen auf, die entlang des Umfangs eines zu klemmenden Wafers angeordnet sind. Die Einzelklemmen sind mittels eines pneumatischen Stellglieds gemeinsam verstellbar.

Aus der JP 07-153785 A ist eine weitgehend spannungsfreie Klemmung eines Wafers bekannt, bei welcher der Wafer zwischen einer unteren Klemmplatte und einer oberen Klemmplatte fixiert wird.

Aus der US 6,155,773 ist eine Handhabungsvorrichtung zum gleichzeitigen Transferieren von zwei Wafern zwischen einer Schleusenkammer und verschiedenen Prozesskammern bekannt, in welchen die Wafer bearbeitet werden können. Der Transfer der beiden Wafer erfolgt mittels zweier Klemmvorrichtungen, die an einem Doppelarm angebracht sind. Die Klemmung der Wafer erfolgt jeweils über einen mechanisch relativ aufwendigen Feder- und Umlenkmechanismus. Das Öffnen der Klemmung erfolgt automatisch bei einer bestimmten Positionierung der Handhabungsvorrichtung über ein Eingriffselement, welches in den Federmechanismus eingreift.

Aus der europäischen Patentanmeldung mit der Nummer EP 1 253 633 A2 ist eine Wafer-Haltevorrichtung bekannt, bei welcher ein Verklemmen des Wafers zwischen mehrfach beweglichen Klemmfingern erfolgt. Die Steuerung der Klemmfinger erfolgt dabei über feste Kolbenstangen. Ähnliche technische Lösungen sind zum Beispiel aus der japanischen Offenlegungsschrift mit der Nummer JP 10296072, der amerikanischen Patentanmeldung mit der Nummer US 2003/00980-48 A1 sowie dem amerikanischen Patent mit der Nummer US 6,578,853 B1 bekannt. All diesen technischen Lösungen ist es gemeinsam, dass Nachteile hinsichtlich der Einfachheit sowie hinsichtlich dem sicheren Fixieren des Wafers bestehen.

Der Erfindung gemäß dem Anspruch 1 liegt die Aufgabe zugrunde, eine Klemmvorrichtung zum lösbaren Fixieren eines Wafers an einem verfahrbaren Wafertisch bereitzustellen, welche Klemmvorrichtung ein mechanisch einfaches und trotzdem ein sicheres Fixieren eines Wafers ermöglicht.

Diese Aufgabe wird gelöst durch den Gegenstand des unabhängigen Anspruchs 1. Vorteilhafte Ausführungsformen der vorliegenden Erfindung sind in den abhängigen Ansprüchen beschrieben.

Mit dem unabhängigen Anspruch 1 wird eine Klemmvorrichtung zum lösbaren Fixieren eines Wafers an einem verfahrbaren Wafertisch beschrieben.

Der Erfindung liegt die Erkenntnis zugrunde, dass eine einfache und zugleich zuverlässige Fixierung eines Wafers auf einem Wafertisch auch ohne die Verwendung eines eigenen Stellglieds, sei es ein elektromechanisches Stellglied wie beispielsweise ein Elektromotor oder ein pneumatisches Stellglied wie beispielsweise ein Hubkolben, realisiert werden kann. Die Betätigung des bewegliches Klemmelements erfolgt gemäß der Erfindung durch einen Antrieb, welcher ohnehin zum Verfahren des Wafertisches benötigt wird. Damit kann die Waferklemmung mit einem sehr geringen aparativen Aufbau realisiert werden.

Da zum Fixieren des Wafers kein eigener Antrieb bzw. Aktor erforderlich ist, kann der beschriebene Verriegelungsmechanismus innerhalb einer sehr kompakten Bauform realisiert werden. Infolge der sowohl elektrisch als auch pneumatisch passiven Ausgestaltung der beschriebenen Klemmvorrichtung ist auch keine Energiezuführung erforderlich, welche die Herstellung der beschriebenen Klemmvorrichtung erschweren und die Herstellkosten entsprechend erhöhen würde. Insgesamt wird durch die Erfindung somit sowohl eine kompakte als auch eine kostengünstige Waferklemmung möglich.

Der Wafer, welcher typischerweise eine Vielzahl von vereinzelten ungehäusten Bauelementen aufweist, die vorzugsweise an einer klebrigen Trägerfolie anhaften, ist in einem mechanisch stabilen Trägerrahmen fixiert. Der Trägerrahmen wird häufig auch als Waferframe bezeichnet. Auf diese Weise kann durch eine zweidimensionale Bewegung des Wafers jedes beliebige Bauelement des Wafers an eine vorgegebene feste Abholposition gefahren werden, von der es von einer Haltevorrichtung eines Bestückkopfes aufgenommen werden kann. Das Ablösen des Bauelements von der Trägerfolie kann in bekannter Weise durch eine Ejektornadel unterstützt werden.

Das stationäre Kontaktelement kann das bewegliche Klemmelement durch eine einfache Berührung oder auch durch einen Eingriff in eine Aussparung des beweglichen Klemmelements aus seiner durch die Federspannung des Federelements bestimmten Sollposition bringen. Die entsprechende mechanische Kopplung kann dabei unmittelbar zwischen dem stationären Kontaktelement und dem bewegliche Klemmelement oder auch mittelbar über ein mechanisches Zwischenglied erfolgen.

Gemäß Anspruch 2 weist die Klemmvorrichtung zusätzlich ein weiteres festes Klemmelement auf, welches ebenfalls an dem Auflageelement angebracht ist. Dabei ist der Wafer zwischen dem festen Klemmelement, dem weiteren festen Klemmelement und dem beweglichen Klemmelement klemmbar, wenn sich das bewegliche Klemmelement in der Schließposition befindet. Dies hat den Vorteil, dass der Wafer durch zumindest eine Dreipunkt-Klemmung in einer genau definierten räumlichen Lage auf dem Wafertisch fixierbar ist.

Gemäß Anspruch 3 ist das Auflageelement ein Rahmen. Dies hat den Vorteil, dass der Waferframe flächig auf dem Auflageelement aufliegen kann, so dass eine besonders genaue Fixierung des Wafers relativ zu dem Wafertisch realisierbar ist.

Gemäß Anspruch 4 weist das Auflageelement eine Aussparung auf, in welcher das bewegliche Klemmelement gelagert ist. Dies hat den Vorteil, dass die Klemmvorrichtung auf einfache Weise derart realisiert werden kann, dass mit Ausnahme des zumindest einen festen Klemmelements keine weiteren Komponenten der Klemmvorrichtung oberhalb der Auflagefläche des Auflageelements hinausragen, wenn sich das bewegliche Klemmelement in der Schließposition befindet. Somit kann sowohl das Einlegen eines Wafers als auch ein Herausnehmen des Wafers auf besonders einfache Weise durch einfache Handbewegungen einer Bedienperson erfolgen, da mit Ausnahme des zumindest einen festen Klemmelements keine weiteren Aufbauten oberhalb der Auflagefläche des Auflageelements die Handhabung des Wafers behindern.

Gemäß Anspruch 5 ist das bewegliche Klemmelement in einer Drehachse schwenkbar gelagert und mittels einer Schwenkbewegung zwischen der Schließposition und der Öffnungsposition bewegbar. Somit kann auf vorteilhafte Weise eine mechanisch sehr einfach zu realisierende Bewegung des Klemmelement für eine zuverlässige Waferklemmung verwendet werden.

Gemäß Anspruch 6 verläuft die Drehachse parallel zu einer Auflagefläche des Auflageelement. Auf diese Weise kann eine symmetrische Waferklemmung realisiert werden, bei der das bewegliche Klemmelement in Bezug auf eine vorgegebene Mittelachse des Wafers in einer symmetrischer Art und Weise an einen Rand des Wafers herangeführt wird. Bevorzugt ist diese Mittelachse eine durch zwei feste Klemmelemente definierte Mittelsenkrechte, die durch den Mittelpunkt des üblicherweise kreisförmigen Wafers verläuft. Somit wird beim Schließen des beweglichen Klemmelements eine ungewollte Verschiebung des Wafers relativ zu dem Auflageelement zuverlässig vermieden. Eine versehentliche Verspannung des Waferframes ist damit nahezu ausgeschlossen.

Gemäß Anspruch 7 umfasst die Klemmvorrichtung zusätzlich (a) ein Schiebeelement, welches relativ zu dem Auflageelement verschiebbar gelagert ist und welches bei einer Bewegung des Auflageelements hin zu der Entnahmeposition durch einen mechanischen Kontakt mit dem stationären Kontaktelement bewegbar ist, und (b) ein flexibles Kraftübertragungselement, welches mit dem Schiebeelement und dem beweglichen Klemmelement verbunden ist. Dabei greift das flexible Kraftübertragungselement außerhalb der Drehachse an dem beweglichen Klemmelement an.

Das flexible Kraftübertragungselement erlaubt eine besonders einfache Umwandlung von einer translatorischen Relativbewegung zwischen dem stationären Kontaktelement und dem Auflageelement bzw. Wafertisch hin zu einer gewünschten Schwenkbewegung des beweglichen Klemmelements. Durch die exzentrische Befestigung des Kraftübertragungselements an dem beweglichen Klemmelement wird auf einfache Weise eine Kraft in ein Drehmoment umgewandelt. Das Kraftübertragungselement kann beispielsweise eine Kette oder eine Schnur aufweisen.

Gemäß Anspruch 8 ist das Kraftübertragungselement ein flexibles Band. Dies hat den Vorteil, dass das Kraftübertragungselement sehr flach sein kann, so dass die gesamte Klemmvorrichtung in einer besonders flachen Bauweise realisiert werden kann.

Gemäß Anspruch 9 weist das flexible Band Aramidfasern auf. Die Verwendung eines Aramidfaserbandes hat den Vorteil, dass es zum einen eine hohe Biegsamkeit aufweiset, so dass die Kraftübertragung zwischen dem Schiebeelement und dem beweglichen Klemmelement relativ verlustfrei erfolgen kann. Zudem hat sich herausgestellt, dass ein Aramidfaserband im Vergleich zu einem flachen Metallband, welches selbstverständlich ebenso als Kraftübertragungselement verwendet werden kann, eine deutlich längere Lebensdauer aufweist. Dies bedeutet, dass mit einem Aramidfaserband die beschriebene Klemmvorrichtung weitaus öfter geöffnet und geschlossen werden kann, als dies mit anderen Bändern möglich wäre.

Mit dem unabhängigen Anspruch 10 wird eine Zuführvorrichtung für in einem Wafer befindliche ungehäuste Bauelemente hin zu einer Abholposition, insbesondere zum Zwecke der Bereitstellung der Bauelemente für einen Bestückautomaten, geschaffen. Die Zuführvorrichtung weist (a) einem Wafertisch, (b) einen ersten Antrieb zum Positionieren des Wafertisches und (c) eine Klemmvorrichtung gemäß einem oben beschriebenen Ausführungsbeispiel auf.

Der erfindungsgemäßen Zuführvorrichtung liegt die Erkenntnis zugrunde, dass die oben beschriebene Klemmvorrichtung in vorteilhafter Weise für eine Bauelement-Zuführvorrichtung verwendet werden kann, bei der Bauelemente direkt von einem mit der beschriebenen Klemmvorrichtung fixierten Wafer einem Bestückautomaten bereitgestellt werden. Dabei kann der Wafertisch beispielsweise innerhalb eines zweidimensionalen Positionierbereichs verschoben werden, so dass jedes auf dem Wafer befindliche Bauelement zum Zwecke der Abholung durch eine Haltevorrichtung eines Bestückkopfes in eine für alle Bauelemente gültige feste Abholposition gebracht werden kann.

Gemäß Anspruch 11 umfasst die Zuführvorrichtung zusätzlich einen zweiten Antrieb zur Positionierung der Klemmvorrichtung relativ zu dem Wafertisch. Dabei ist der erste Antrieb zum eindimensionalen Positionieren des Wafertisches entlang einer Verschieberichtung vorgesehen. Durch eine geeignete Überlagerung der durch beide Antriebe verursachten Bewegungen kann somit eine zweidimensionale Bewegung des Wafers parallel zu der Oberfläche der Wafers erreicht werden. Bei ausreichend großen Bewegungsbereichen der beiden Antriebe kann somit jedes Bauelement an die gewünschte Abholposition durch eine entsprechende Parallelverschiebung des Wafers gebracht werden.

Gemäß Anspruch 12 ist der zweite Antrieb zum Drehen der Klemmvorrichtung um eine Rotationsachse vorgesehen. Die Rotationsachse ist dabei senkrecht zu der Oberfläche des Wafers orientiert und verläuft bevorzugt durch den Mittelpunkt des Wafers. Somit kann durch eine Überlagerung einer durch den ersten Antrieb erzeugten Linearbewegung und durch eine durch den zweiten Antrieb erzeugten Drehbewegung jedes auf dem Wafer befindliche Bauelement an die gewünschte Abholposition transferiert werden.

Mit dem unabhängigen Anspruch 13 wird eine Bestückvorrichtung zum automatischen Bestücken von Bauelementeträgern mit Bauelementen geschaffen. Die Bestückvorrichtung umfasst (a) eine Zuführvorrichtung gemäß einem oben beschriebenen Ausführungsbeispiel zum Zuführen der Bauelemente an eine Abholposition und (b) einen Bestückkopf zum Aufnehmen der Bauelemente von der Abholposition, zum Transportieren der Bauelemente und zum Aufsetzen der Bauelemente an vorgegebenen Positionen auf dem Bauelementeträger.

Der erfindungsgemäßen Bestückvorrichtung liegt die Erkenntnis zugrunde, dass die oben beschriebene Zuführvorrichtung in besonders vorteilhafter Weise für einen Bestückautomaten verwendet werden kann, welcher, ohne dass ein aufwendiges Umpacken der Bauelemente erforderlich ist, ungehäuste Bauelemente direkt von einem Wafer entnehmen und die entnommenen Bauelemente in bekannter Weise auf einen Bauelementeträger an vorgegebenen Aufsetzpositionen platzieren kann.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine Bestückvorrichtung, mit der ungehäuste Bauelemente direkt von einem Wafer abgeholt werden können,
- Figur 2: ein Wafer-Auflageelement mit zwei festen Anschlagelementen,
- Figur 3a: einen Wafer-Verriegelungsmechanismus in einer Schließposition, in der ein Wafer zwischen einem Schließbügel und nicht dargestellten Klemmelementen festgeklemmt ist, und
- Figur 3b: den in Figur 3a dargestellten Wafer-Verriegelungsmechanismus in einer Öffnungsposition, in der ein Wafer eingelegt und oder ein eingelegter Wafer entnommen werden kann.

An dieser Stelle bleibt anzumerken, dass sich in der Zeichnung die Bezugszeichen von gleichen oder von einander entsprechenden Komponenten lediglich in ihrer ersten Ziffer unterscheiden.

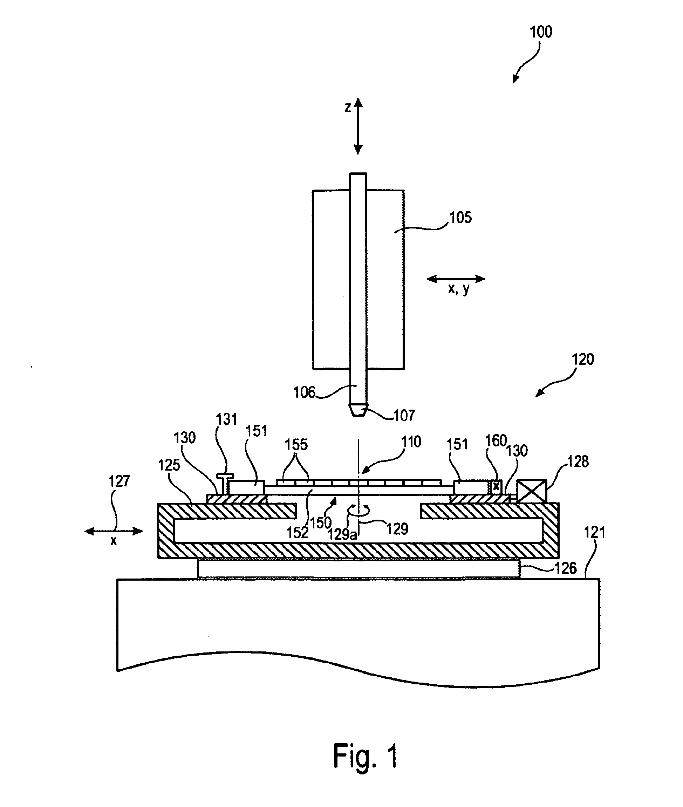

Figur 1 zeigt gemäß einem Ausführungsbeispiel der Erfindung einen Bestückautomaten 100, mit dem ungehäuste Bauelemente 155 direkt von einem Wafer 150 abgeholt werden können. Der Bestückautomat 100 weist einen Bestückkopf 105 auf, welcher in bekannter Weise mittel eines nicht dargestellten x-y-Positioniersystems zwischen der dargestellten Abholposition und einem nicht dargestellten Bestückbereich verfahren werden kann. In dem Bestückbereich werden die Bauelemente 155 in bekannter Weise auf einen Bauelementeträger bestückt. Der Bestückkopf 105 umfasst einen hohlen Schaft 106, welcher in bekannter Weise mittels eines nicht dargestellten Antriebs relativ zu dem Bestückkopf 105 entlang der z-Achse verfahren werden kann. An dem hohlen Schaft 106 befindet sich eine Saugpipette 107 zum temporären Aufnehmen eines der Bauelemente 155 direkt von dem Wafer 150.

Der Wafer 150 weist einen Waferframe 151 auf. An dem Waferframe 151 befindet sich eine klebrige Trägerfolie 152, an der die ungehäusten und in bekannter Weise vereinzelten Bauelemente 155 anheften.

Gemäß dem hier dargestellten Ausführungsbeispiel der Erfindung erfolgt die Aufnahme der Bauelemente 155 durch den Bestückkopf 105 von einer Zuführvorrichtung 120 an einer stationären Abholposition 110. Das für eine Bauelementaufnahme erforderliche Ablösen der Bauelemente 155 von der Trägerfolie 152 kann durch eine nicht dargestellte Ejectornadel unterstützt werden, welche sich unmittelbar unterhalb der Aufnahmeposition befindet.

In der Aufnahmeposition können nacheinander sämtliche Bauelemente 155 des Wafers 150 bereitgestellt werden. Dies erfolgt gemäß dem hier dargestellten Ausführungsbeispiel durch eine Überlagerung zweier Bewegungen. Eine erste Bewegung besteht darin, dass ein Wafertisch 125 mittels eines Antriebs 126 relativ zu einem stationären Chassis 121 entlang einer Verschieberichtung 127 in x-Richtung verschoben wird. Die zweite Bewegung besteht in einer Drehbewegung 129a des Wafers 150 um eine Drehachse 129, welche bevorzugt aber nicht notwendigerweise mit dem Mittelpunkt des Wafers 150 zusammen fällt. Zu Erzeugung der Drehbewegung 129a ist ein Antrieb 128 vorgesehen, welcher in geeigneter Weise mit einem Drehteller 130 gekoppelt ist. Gemäß dem hier dargestellten Ausführungsbeispiel ist der Drehteller 130 ein Rahmen, der als Auflageelement für den Waferframe 151 dient.

Der Waferframe 151 ist mittels einer Klemmung zwischen einem festen Anschlagelement 131 und einem Verriegelungsmechanismus 160 an dem Drehteller 130 lösbar fixiert.

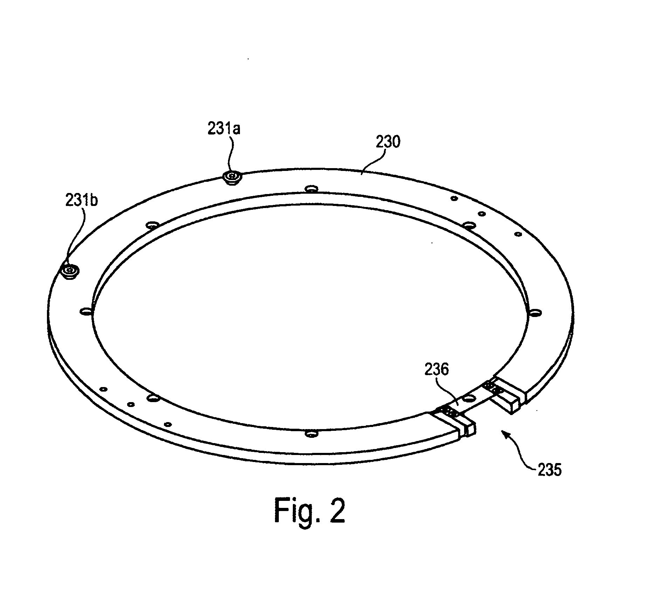

Figur 2 zeigt den Drehteller 130, welcher nunmehr mit dem Bezugszeichen 230 versehen ist. Der Drehteller 230 weist zwei feste Anschlagelemente 231a und 231b auf. Die Anschlagelemente 231a und 231b definieren die relative räumliche Lage zwischen einem nicht dargestellten Waferframe und dem Drehteller 230. Dabei wird bei Auflegen eines Wafers auf den Drehteller 230 der Frame des Wafers gegen die beiden Anschlagelemente 231a und 231b geschoben. Anschließend wird ein in Figur 2 nicht dargestellter Verriegelungsmechanismus betätigt, welcher in einer Aussparung 235 des Rahmens 230 angeordnet ist. Um die mechanische Stabilität des Drehtellers 230 nicht zu verringern, weist der Drehteller 230 an der Stelle der Aussparung 235 einen Verbindungssteg 236 auf.

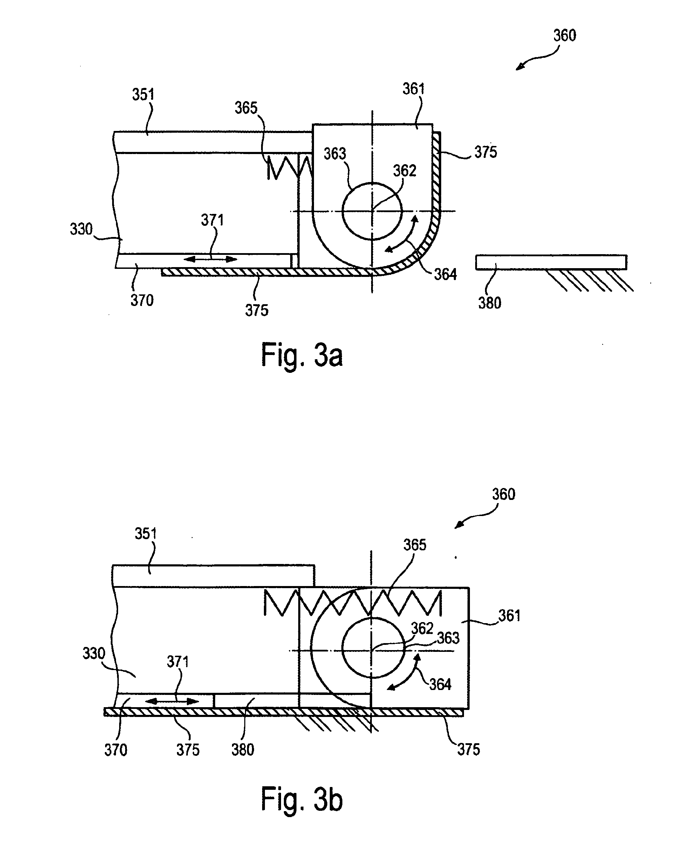

Figur 3a zweigt einen Wafer-Verriegelungsmechanismus 360, welcher sich in der in Figur 2 dargestellten Aussparung 235 befindet. Der Verriegelungsmechanismus 360 ist in einer Schließposition dargestellt, in der ein auf einem Drehteller 330 befindlicher Waferframe 351 zwischen einem beweglichen Klemmelement bzw. Schließbügel 361 und in Figur 3a nicht dargestellten festen Anschlagelementen (siehe Figur 2) geklemmt ist. Der Schließbügel 361 ist mittels einer Lagerung 363 in einer Drehachse 362 schwenkbar gelagert. Die entsprechende Schwenkrichtung ist mit dem Bezugszeichen 364 gekennzeichnet.

Der Schließbügel 361 wird mittels einer Feder 365, welche bevorzugt eine so genannte Schenkelfeder ist, in die in Figur 3a dargestellte Schließposition vorgespannt. Auf diese Weise erfolgt eine automatische Klemmung des Waferframes 351 ausschließlich durch die Federkraft der Feder 365, ohne dass ein speziell für die Waferklemmung verwendetes mechanisches Stellglied zur Erzeugung einer entsprechenden Klemmkraft erforderlich ist.

Zum Öffnen des Schließbügels 361 ist ein Kraftübertragungselement 375 vorgesehen, welches gemäß dem hier dargestellten Ausführungsbeispiel ein Band 375 ist, welches Aramidfasern aufweist. Ein erstes Ende des Bandes 375 ist an einem Schiebeelement 370 befestigt, welches relativ zu dem Auflageelement 230 entlang einer Verschieberichtung 371 verschiebbar gelagert ist.

Bei einem Verfahren des Auflageelement 230 hin zu einer Entnahmeposition wird ein mechanischer Kontakt zwischen einem stationären Kontaktelement bzw. Festanschlag 380 und dem Schiebeelement 370 hergestellt, so dass dieses relativ zum Auflageelement 230 nach links verschoben wird. Der mechanische Kontakt kann dabei durch eine einfache Berührung oder auch durch einen Eingriff in eine Aussparung des Schiebeelements erfolgen.

Ein zweites Ende des Bandes 375 ist an dem Schließbügel 361 befestigt. Bei einem Verschieben des Schiebeelements 370 wird demzufolge der Schließbügel 361 entgegen der Federkraft der Feder 365 in eine Öffnungsposition geschwenkt. Figur 3b zeigt den Wafer-Verriegelungsmechanismus 360 in dieser Öffnungsposition, in der ein zuvor festgeklemmter Wafer entnommen bzw. ein Wafer in die durch die beiden Anschlagelemente (siehe Figur 2) definierte Position eingelegt werden kann.

Es wird darauf hingewiesen, dass die hier beschriebenen Ausführungsformen lediglich eine beschränkte Auswahl an möglichen Ausführungsvarianten der Erfindung darstellen. Insbesondere kann der Schließbügel 361 nicht nur eine Klemmbacke sondern zwei oder auch mehr Klemmbacken aufweisen, so dass der Wafer-Verriegelungsmechanismus 360 an mehreren Stellen an dem Waferframe 351 angreifen kann. Selbstverständlich ist es auch möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Bestückautomat
- 105: Bestückkopf
- 106: hohler Schaft
- 107: Saugpipette
- 110: Abholposition
- 120: Zuführvorrichtung
- 121: Chassis
- 125: Wafertisch
- 126: Antrieb Wafertisch
- 127: Verschieberichtung
- 128: Antrieb Drehteller / Drehantrieb
- 129: Drehachse
- 129a: Drehrichtung
- 130: Auflageelement / Rahmen / Drehteller
- 131: Klemmelement / Anschlag
- 150: Wafer
- 151: Waferframe
- 152: klebrige Trägerfolie
- 155: vereinzeltes Bauelement
- 160: Verriegelungsmechanismus

- 230: Auflageelement / Rahmen / Drehteller
- 231a: Klemmelement / Anschlag
- 231b: Klemmelement / Anschlag
- 235: Aussparung
- 236: Verbindungssteg

- 330: Auflageelement / Rahmen / Drehteller
- 351: Waferframe
- 360: Verriegelungsmechanismus
- 361: bewegliches Klemmelement / Schließbügel
- 362: Drehachse
- 363: Lagerung
- 364: Drehrichtung / Schwenkrichtung
- 365: Federelement / Schenkelfeder
- 370: Schiebeelement
- 371: Verschieberichtung
- 375: Kraftübertragungselement / flexibles Band / Aramidband
- 380: stationäres Kontaktelement / Festanschlag

## Patentansprüche

1. Klemmvorrichtung zum lösbaren Fixieren eines Wafers (150) an einem verfahrbaren Wafertisch (125), aufweisend
• ein Auflageelement (130, 230, 330),
• ein festes Klemmelement (131, 231a), welches an dem Auflageelement (130, 230, 330) angebracht ist,
• ein bewegliches Klemmelement (160, 361), welches ebenfalls an dem Auflageelement (130, 230, 330) angebracht ist und welches für eine Bewegung zwischen einer Öffnungsposition und einer Schließposition ausgebildet ist, wobei ein Wafer (150) zwischen dem festen Klemmelement (131, 231a) und dem beweglichen Klemmelement (160, 361) klemmbar ist, wenn sich das bewegliche Klemmelement (160, 361) in der Schließposition befindet, und
• ein Federelement (365), welches derart mit dem beweglichen Klemmelement (160, 361) gekoppelt ist, dass das bewegliche Klemmelement (160, 361) in Richtung der Schließposition vorgespannt ist,
**gekennzeichnet durch**
• ein Schiebeelement (370), welches relativ zu dem Auflageelement (130, 230, 330) verschiebbar gelagert ist,
• ein flexibles Kraftübertragungselement (375), welches mit dem Schiebeelement (370) und dem beweglichen Klemmelement (160, 361) verbunden ist, und
• ein stationäres Kontaktelement (380),
wobei das flexible Kraftübertragungselement (375) ausgebildet ist, um das bewegliche Klemmelement (160, 361) aus der Schließposition in die Öffnungsposition zu bewegen, wenn das Schiebelement (370) sich mit Bezug auf das Auflageelement parallel verschiebt, und das stationäre Kontaktelement (380)verwendet wird, mit dem Schiebeelement (370) in mechanischen Kontakt zu treten, um das bewegliche Klemmelement (160, 361) in der Öffnungsposition zu halten.

2. Klemmvorrichtung nach Anspruch 1, zusätzlich aufweisend
• ein weiteres festes Klemmelement (231b), welches ebenfalls an dem Auflageelement (130, 230, 330) angebracht ist, wobei der Wafer (150) zwischen dem festen Klemmelement (131, 231a), dem weiteren festen Klemmelement (231b) und dem beweglichen Klemmelement (160, 361) klemmbar ist, wenn sich das bewegliche Klemmelement (160, 361) in der Schließposition befindet.

3. Klemmvorrichtung nach einem der Ansprüche 1 bis 2, bei der das Auflageelement ein Rahmen (130, 230, 330) ist.

4. Klemmvorrichtung nach Anspruch 3, bei der das Auflageelement (130, 230, 330) eine Aussparung (235) aufweist, in welcher das bewegliche Klemmelement (160, 361) gelagert ist.

5. Klemmvorrichtung nach einem der Ansprüche 1 bis 4, bei der das bewegliche Klemmelement (160, 361) in einer Drehachse (362) schwenkbar gelagert ist und mittels einer Schwenkbewegung (364) zwischen der Schließposition und der Öffnungsposition bewegbar ist.

6. Klemmvorrichtung nach Anspruch 5, bei der die Drehachse (362) parallel zu einer Auflagefläche des Auflageelements (130, 230, 330) verläuft.

7. Klemmvorrichtung nach Anspruch 6, wobei das Kraftübertragungselement ein flexibles Band (375) ist.

8. Klemmvorrichtung nach Anspruch 7, wobei das flexible Band (375) Aramidfasern aufweist.

9. Zuführvorrichtung (120) für in einem Wafer (150) befindliche ungehäuste Bauelemente (155) hin zu einer Abholposition (110), insbesondere zum Zwecke der Bereitstellung der Bauelemente (155) für einen Bestückautomaten (100), die Zuführvorrichtung (120) aufweisend
• einen Wafertisch (125),
• einen ersten Antrieb (126) zum Positionieren des Wafertisches (125), und
• eine Klemmvorrichtung nach einem der Ansprüche 1 bis 8.

10. Zuführvorrichtung nach Anspruch 9, zusätzlich aufweisend
• einen zweiten Antrieb (128) zur Positionierung der Klemmvorrichtung relativ zu dem Wafertisch (125),
wobei
der erste Antrieb (126) zum eindimensionalen Positionieren des Wafertisches (125) entlang einer Verschieberichtung (127) vorgesehen ist.

11. Zuführvorrichtung nach Anspruch 10, bei der der zweite Antrieb (128) zum Drehen der Klemmvorrichtung um eine Rotationsachse (129) vorgesehen ist.

12. Bestückvorrichtung zum automatischen Bestücken von Bauelementeträgern mit Bauelementen (155), aufweisend
• eine Zuführvorrichtung nach einem der Ansprüche 9 bis 11 zum Zuführen der Bauelemente (155) an eine Abholposition (110) und
• einen Bestückkopf (105) zum Aufnehmen der Bauelemente (155) von der Abholposition (110), zum Transportieren der Bauelemente (155) und zum Aufsetzen der Bauelemente (155) an vorgegebenen Positionen auf dem Bauelementeträger.

## Claims

1. A clamping device for releasably attaching a wafer (150) to a moveable wafer table (125), comprising:
• a support element (130, 230, 330);
• a fixed clamping element (131, 231a), which is mounted on the support element (130, 230, 330);
• a moveable clamping element (160, 361), which is also mounted on the support element (130, 230, 330) and which is adapted to move between an open position and a closed position, whereby a wafer (150) can be clamped between the fixed clamping element (131, 231a) and the moveable clamping element (160, 361) when the moveable clamping element (160, 361) is in the closed position; and
• a spring element (365), which is coupled with the moveable clamping element (160, 361) in such a manner that the moveable clamping element (160, 361) is preloaded in the direction of the closed position;
**characterized by**
• a slide element (370), which is moveably mounted relative to the support element (130, 230, 330);
• a flexible load transmitting element (375), which is connected to the slide element (370) and the moveable clamping element (160, 361); and
• a stationary contact element (380);
wherein the flexible load transmitting element (375) is adapted to move the moveable clamping element (160, 361) from the closed position into the open position when the slide element (370) is displaced parallel to the support element and the stationary contact element (380) is used such that it comes into mechanical contact with the slide element (370) in order to hold the moveable clamping element (160, 361) in the open position.

2. The clamping device as claimed in claim 1, further comprising:
• a further fixed clamping element (231b), which is also mounted on the support element (130, 230, 330), whereby the wafer (150) can be clamped between the fixed clamping element (131, 231a), the further fixed clamping element (231b) and the moveable clamping element (160, 361) when the moveable clamping element (160, 361) is in the closed position.

3. The clamping device as claimed in claim 1 or claim 2, in which the support element is a frame (130, 230, 330).

4. The clamping device as claimed in claim 3, in which the support element (130, 230, 330) comprises a recess (235) in which the moveable clamping element (160, 361) is mounted.

5. The clamping device as claimed in one of claims 1 to 4, in which the moveable clamping element (160, 361) is pivotally mounted about a rotational axis (362) and is moveable between the closed position and the open position by means of a pivotal movement (364).

6. The clamping device as claimed in claim 5, in which the rotational axis (362) is parallel to a support surface of the support element (130, 230, 330).

7. The clamping device as claimed in claim 6, in which the load transmitting element is a flexible strip (375).

8. The clamping device as claimed in claim 7, in which the flexible strip (375) comprises aramid fibers.

9. A device (120) for conveying uncased components (155) in a wafer (150) to a pick-up position (110), in particular for the purposes of providing components (155) for a pick and place machine (100), the conveying device (120) comprising:
• a wafer table (125);
• a first drive (126) for positioning the wafer table (125); and
• a clamping device as claimed in one of claims 1 to 8.

10. A conveying device as claimed in claim 9, further comprising:
• a second drive (128) for positioning the clamping device relative to the wafer table (125); wherein
the first drive (126) is provided for one-dimensional positioning of the wafer table (125) along a shifting direction (127).

11. A conveying device as claimed in claim 10, in which the second drive (128) is provided for rotating the clamping device about a rotational axis (129).

12. A pick and place machine for automatically placing components (155) on component carriers, comprising:
• a conveying device as claimed in one of claims 9 to 11 for conveying the components (155) to a pick-up position (110); and
• a placement head (105) for taking the components (155) from the pick-up position (110), for transporting the components (155) and for placing the components (155) at predetermined positions on the component carrier.

## Revendications

1. Dispositif de serrage dévolu au blocage à demeure libérable d'une plaquette de silicium (150) sur un plateau mobile (125) de support de plaquettes, comprenant
• un élément d'appui (130, 230, 330),
• un élément fixe de serrage (131, 231a) mis en place sur ledit élément d'appui (130, 230, 330),
• un élément mobile de serrage (160, 361) qui est pareillement mis en place sur ledit élément d'appui (130, 230, 330) et est réalisé pour effectuer un mouvement entre une position d'ouverture et une position de fermeture, une plaquette de silicium (150) pouvant être enserrée entre ledit élément fixe de serrage (131, 231a) et ledit élément mobile de serrage (160, 361) lorsque ledit élément mobile de serrage (160, 361) occupe la position de fermeture, et
• un élément élastique (365) couplé audit élément mobile de serrage (160, 361) de façon telle que ledit élément mobile de serrage (160, 361) soit précontraint en direction de la position de fermeture,
**caractérisé par**
• un élément coulissant (370) monté à coulissement vis-à-vis de l'élément d'appui (130, 230, 330),
• un élément flexible (375) de transmission de forces, relié audit élément coulissant (370) et à l'élément mobile de serrage (160, 361), et
• un élément stationnaire de contact (380),
ledit élément flexible (375) de transmission de forces étant réalisé de manière à mouvoir ledit élément mobile de serrage (160, 361) de la position de fermeture à la position d'ouverture lorsque ledit élément coulissant (370) coulisse parallèlement à l'élément d'appui, et ledit élément stationnaire de contact (380) étant utilisé pour entrer en contact mécanique avec ledit élément coulissant (370), afin de maintenir ledit élément mobile de serrage (160, 361) dans la position d'ouverture.

2. Dispositif de serrage selon la revendication 1, additionnellement pourvu
• d'un élément fixe de serrage (231b) supplémentaire, pareillement mis en place sur l'élément d'appui (130, 230, 330), la plaquette de silicium (150) pouvant être enserrée entre l'élément fixe de serrage (131, 231a), ledit élément fixe de serrage (231b) supplémentaire, et l'élément mobile de serrage (160, 361), lorsque ledit élément mobile de serrage (160, 361) occupe la position de fermeture.

3. Dispositif de serrage selon l'une des revendications 1 à 2, dans lequel l'élément d'appui est un cadre (130, 230, 330).

4. Dispositif de serrage selon la revendication 3, dans lequel l'élément d'appui (130, 230, 330) comporte un évidement (235) dans lequel l'élément mobile de serrage (160, 361) est logé.

5. Dispositif de serrage selon l'une des revendications 1 à 4, dans lequel l'élément mobile de serrage (160, 361) est monté à pivotement suivant un axe de rotation (362) et peut être déplacé, par un mouvement pivotant (364), entre la position de fermeture et la position d'ouverture.

6. Dispositif de serrage selon la revendication 5, dans lequel l'axe de rotation (362) s'étend parallèlement à une surface d'appui de l'élément d'appui (130, 230, 330).

7. Dispositif de serrage selon la revendication 6, dans lequel l'élément de transmission de forces est une bande flexible (375).

8. Dispositif de serrage selon la revendication 7, dans lequel la bande flexible (375) présente des fibres d'aramide.

9. Dispositif d'alimentation (120) conçu pour convoyer, vers une position d'enlèvement (110), des composants nus (155) intégrés dans une plaquette de silicium (150), notamment en vue de délivrer lesdits composants (155) à un système de garnissage automatique (100), ledit dispositif d'alimentation (120) comprenant
• un plateau (125) de support de plaquettes,
• un premier entraînement (126) affecté au positionnement dudit plateau (125) de support de plaquettes, et
• un dispositif de serrage conforme à l'une des revendications 1 à 8.

10. Dispositif d'alimentation selon la revendication 9, additionnellement pourvu
• d'un second entraînement (128) affecté au positionnement du dispositif de serrage vis-à-vis du plateau (125) de support de plaquettes,
le premier entraînement (126) étant prévu pour le positionnement unidimensionnel dudit plateau (125) de support de plaquettes le long d'une direction de coulissement (127).

11. Dispositif d'alimentation selon la revendication 10, dans lequel le second entraînement (128) est prévu pour faire tourner le dispositif de serrage autour d'un axe de rotation (129) .

12. Dispositif de garnissage dédié au garnissage automatique de supports de composants par des composants (155), comprenant
• un dispositif d'alimentation conforme à l'une des revendications 9 à 11, conçu pour convoyer lesdits composants (155) vers une position d'enlèvement (110), et
• une tête de garnissage (105) conçue pour prélever lesdits composants (155) depuis ladite position d'enlèvement (110), pour transporter lesdits composants (155) et pour mettre en place lesdits composants (155) sur le support de composants, en des emplacements préétablis.
